# EUROPEAN PATENT SPECIFICATION

(11) **EP 0 421 203 B1**
(45) Date of publication and mention of the grant of the patent: **03.01.1996**
(21) Application number: 90118127.1
(22) Date of filing: 20.09.1990
(51) Int. Cl.: H01L 21/316

(54) **An integrated circuit structure with a boron phosphorus silicate glass composite layer on semiconductor wafer and improved method for forming same**
Integrierte Schaltungsstruktur mit einer zusammengesetzten Borphosphorsilikatglasschicht auf einer Halbleiterscheibe und verbesserte Herstellungsmethode dafür
Structure de circuit intégré comportant une couche de verre boro-phosphor-silicaté sur substrat semi-conducteur et son procédé de fabrication

(30) Priority: 28.09.1989 US 413800
(43) Date of publication of application: 10.04.1991
(73) Proprietor: APPLIED MATERIALS INC., Santa Clara California 95052 (US)
(72) Inventor: Lee, Peter Wai-Man, Fremont, California 94539 (US); Wang, David N. K., Saratoga, California 95070 (US); Nagashima, Makoto, 1223 Yamizaki-Cho, Machida-Shi (JP); Fukuma, Kazuto, Ibaraki-Shi, Osaka-Fu (JP); Sato, Tetsuya, 1073-1 Mabashi, Narita-Shi (JP)
(74) Representative: Kahler, Kurt, Dipl.-Ing.

(56) References cited:
- EP-A- 0 272 140
- JOURNAL OF VACUUM SCIENCE & TECHNOLOGY B, vol. 4, no. 3, May/June 1986, pp. 732-744; F.S. BECKER et al.: "Process and film characterization of low pressure tetraethylorthosilicate-borophosphosilicate glass"
- SOLID STATE TECHNOLOGY, vol. 26, no. 10, October 1983, pp. 217-224; I. AVIGAL: "Inter-metal dielectric and passivation-related properties of plasma BPSG"
- JOURNAL OF THE ELECTROCHEMICAL SOCIETY, vol. 113, no. 9, September 1986, pp. 1943-1950; Y. SHIOYA et al.: "Comparison of phosphosilicate glass film deposited by three different chemical vapor deposition methods"

## Description

### 1. Field of the Invention

This invention relates to the processing of integrated circuit structures.More particularly, this invention relates to the formation of a boron phosphorus silicate glass composite layer on a semiconductor wafer and an improved method of forming same.

### 2. Description of the Related Art

Boron phosphorus silicate glass (BPSG) has been used as an insulating layer applied over stepped surfaces of integrated circuit structures formed on semiconductor wafers. BPSG is used over stepped surfaces because of its low melting temperature which permits subsequent heating of the layer to flow the glass to thereby planarize the structure.

Various processes have been used to form the BPSG layer over the stepped surface on the semiconductor wafer. A plasma-assisted chemical vapor deposition (CVD) process using silane (SiH₄) together with boron and phosphorus doping materials such as, for example, trimethylphosphate (TMP) and trimethylborate (TMB), has been used in the past (cf. e.g, "Solid State Technology" 26 (1983), 217-224).

However, one problem which can occur when forming such a layer over stepped surfaces resulting from, for example, closely spaced apart raised lines or narrow trenches, is that of the formation of voids.

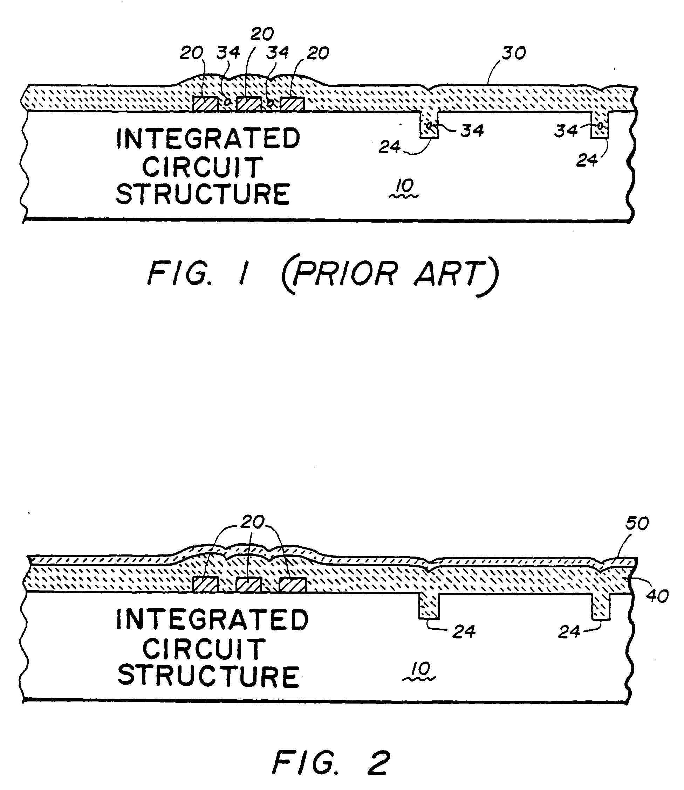

Referring to Figure 1, which shows a prior art formation of a boron phosphorus silicate layer 30, an integrated circuit structure 10 is shown having trenches 24 and raised lines 20 thereon which may, for example, be metal or polysilicon lines.

When such a prior art BPSG layer 30 is applied over the structure, void formation, indicated at 34, occurs in the cavities between closely spaced apart lines 20 or in narrow trenches 24 when the material of BPSG layer 30 being formed deposits or grows on the sidewalls of the cavities, comprising either the space between adjacent lines 20 or the space in trenches 24, faster than it grows or deposits on the bottom of the cavities so that the side surfaces neck together at or near the top of the cavity before the cavity is completely filled, leaving voids or unfilled spaces 34 in the cavity which, upon subsequent sectioning of the wafer, can be visually seen by a 2000x power microscope.

When a plasma-assisted CVD silane process, such as described above, is utilized in the construction of VLSI integrated circuit structures, such as 1 megabit DRAMs, where spacing between metal lines is about 1.2 nm or less, only about 30% to 50% of the resulting step coverage is free of such voids.

With the increasing density of integrated circuit structures, for example, in the construction of 4 and 16 megabit DRAMs, the step coverage of a BPSG layer formed by such a plasma-assisted CVD silane process is unacceptable. Because of this, improved processes have been developed for forming BPSG insulating layers over stepped semiconductor wafers having fine pitch lines or high aspect ratio trenches, e.g., 0.5 to 1 nm spacing between lines or sidewalls of trenches.

One such process is a plasma-assisted CVD process which utilizes tetraethylorthosilicate (TEOS) as the source of silicon together with O₃, and boron and phosphorus dopants to form the BPSG layer. While this process results in better step coverage, the result is still only about 70% void-free coverage of lines having 0.8 to 1 nm spacing such as found in 4 megabit DRAMs.

A CVD process which uses tetraethylorthosilicate as the source of silicon and which does not utilize a plasma, but uses pressures ranging from 7,8 × 10³ Pa (60 Torr) up to atmospheric pressure (0,99 × 10⁵ Pa)_{,}has also been developed for depositing BPSG layers. Use of this process has resulted in 100% void-free step coverage over lines spaced as close as 0.5 nm. Typically, formation of a BPSG layer with a non-plasma-assisted process includes the further steps of densifying the CVD formed BPSG layer at temperatures of about 700°C, followed by a wet etch to clean the wafer, and then a final high temperature flow step to planarize the structure (cf. e.g. "Journal of Vacuum Sciences & Technology B", 4 (1986) 732-744).

The densification step, however, takes time and also generates undesirable particles, while the wet etch step preferentially leaches out boron from the BPSG layer and attacks the sidewalls of the steps or trenches. Furthermore, the BPSG layer formed by this prior art process has high tensile stress, resulting in cracks in the layer. The BPSG layer formed by this process is also hygroscopic, moisture adsorbed into the layer can result in conversion of the boron dopant in the glass to B₂O₃ or even recrystallization of the boron to boric acid.

There remains a need for a BPSG layer formed on a stepped surface of a semiconductor wafer, and an improved method for making same, wherein voids will not be formed in the BPSG layer as it deposits in the areas between closely spaced raised lines and/ or high aspect ratio trenches, and wherein the surface of the BPSG layer is not hygroscopic or in other ways subject to loss of boron from the layer which could, otherwise, affect the ability to flow the glass to planarize the structure.

### Summary of the Invention

For solving that object of this invention to provide a composite BPSG layer on a stepped surface of a semiconductor wafer characterized by the absence of voids in areas between closely spaced apart raised portions of the wafer and having a surface which is not hygroscopic to mitigate loss of boron from the BPSG layer, there is proposed an integrated circuit structure according to claim 9 and a method for forming same according to claim 1.

Further features of the invention are characterized in subclaim 10 (integrated circuit structure) and subclaims 2 to 8 (method), respectively. The structure of the composite layer and the forming method according to the invention will be apparent from the following description and accompanying drawings.

### Brief Description of the Drawings

Figure 1 is a vertical cross-sectional view of a prior art structure representing a semiconductor wafer with a stepped surface formed by closely spaced apart raised lines and high aspect ratio trenches and a planarizing layer of BPSG with voids shown formed in the cavities between the raised lines and in the trenches.

Figure 2 is a vertical cross-sectional view of a semiconductor wafer having a stepped surface showing the composite BPSG layer of the invention comprising a void-free BPSG layer formed by CVD TEOS deposition and a capping layer of BPSG formed by plasma-assisted CVD TEOS deposition.

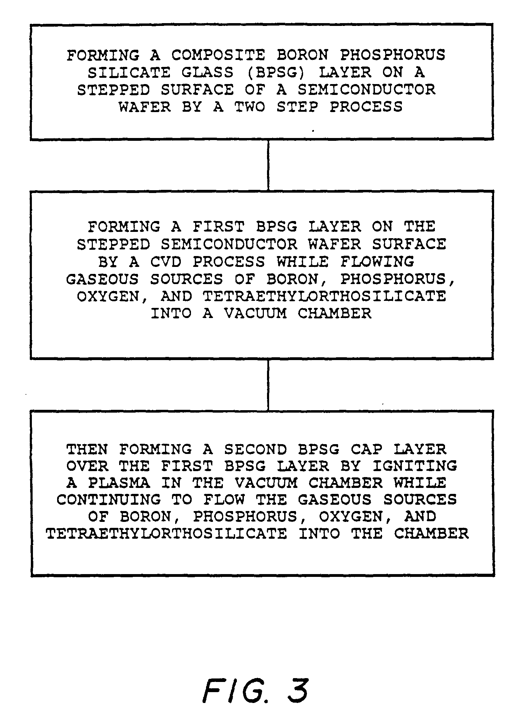

Figure 3 is a flowsheet illustrating the process of the invention.

### Detailed Description of the Invention

In accordance with the invention, a composite BPSG insulating and planarizing layer is formed over stepped surfaces of a semiconductor wafer by a novel two step process. The composite BPSG layer is characterized by the absence of discernible voids and a surface which is resistant to loss of boron in a subsequent etching step.

The two step deposition process comprises a first step to form a void-free BPSG layer 40, as shown in Figure 2, by a CVD deposition using gaseous sources of phosphorus and boron dopants and tetraethylorthosilicate (TEOS) as the source of silicon; and then a second step to form a capping layer 50 of BPSG by a plasma-assisted CVD deposition process while again using gaseous sources of phosphorus and boron dopants, and TEOS as the source of silicon, to provide a BPSG cap layer having a surface which is non-hygroscopic and resistant to loss of boron by subsequent etching.

The term "stepped surfaces of a semiconductor wafer", as used herein, is meant to include structures such as raised lines on a wafer surface or a wafer surface having trenches formed therein, particularly high aspect ratio trenches, i.e., trenches with depth to width ratios greater than 1. Therefore, expressions herein, such as "raised portions of the wafer", are meant to describe surface topographies which include both raised lines as well as the sidewalls of narrow trenches formed in the wafer.

For the first deposition step, the semiconductor wafer is placed on a support base or susceptor in a CVD chamber of a vacuum deposition apparatus such as, for example, a 5000 Series System available form Applied Materials, Inc. The wafer and the susceptor are heated to a temperature within a range of from about 390°C to about 600°C, preferably from about 390°C to about 499°C, and then maintained within this temperature range throughout the deposition. The chamber is maintained at a pressure within a range of from 5,2 × 10³ Pa (40 Torr) to 0.99 × 10⁵ Pa (760 Torr) Pa during the deposition.

A gaseous mixture is then admitted into the deposition chamber comprising one or more gaseous sources of boron, one or more gaseous sources of phosphorus, a gaseous source of oxygen, and tetraethylorthosilicate (TEOS) as the gaseous source of silicon. A carrier gas such as argon, nitrogen, or helium may also be present in the mixture of gases.

The gaseous sources of boron and phosphorus may comprise any gases respectively containing boron or phosphorus and other materials which will not interfere with the glass deposition and which are capable of decomposing to form a gas capable of reacting with both the TEOS and the O₃ in the specified pressure and temperature ranges of the process. Preferably, such gaseous sources of boron and phosphorus will be organic boron-containing and phosphorus-containing gases which will decompose at the deposition temperature with the remainder of the components of the gases volatilizing off and being removed by the vacuum pumping system used to maintain the vacuum in the chamber.

Examples of such gaseous sources of boron and phosphorus include triethylphosphine (TEP), trimethylphosphate (TMP), trimethylborate (TMB), (trimethylsilyl)phosphate, (trimethylsilyl)borate, and mixtures of same.

It should be noted, however, that the gaseous sources of boron or phosphorus need not be organic compounds. But the boron and/or phosphorus-containing compound or compounds used must not be so reactive as to react with the O₃ before decomposition of the TEOS. Hence, the requirement is that the compound be reactive with both the O₃ and the decomposition products of the TEOS. It has been found that boron and/or phosphorus-containing organic compounds such as those recited above decompose sufficiently slow under the specified reaction conditions so as to permit the desired reaction with both the O₃ and the TEOS decomposition products.

The gaseous sources of boron and phosphorus dopants may be mixed with a suitable nonreactive carrier gas such as argon or helium. The amount of the gaseous sources of boron and phosphorus present in such a carrier gas/gaseous dopant source mixture may range from about 2 to 100 wt.% of the dopant/ carrier gas mixture with the balance comprising the carrier gas. It should be noted here that for some volatile organic dopant sources, the use of such a carrier gas is unnecessary.

The gaseous source of boron (or mixture with carrier gas) is flowed into the CVD chamber at a flow rate within a range of from about 10 to about 3000 standard cubic centimeters per minute (sccm), and the gaseous source of phosphorus (or mixture with carrier gas) is also flowed into the chamber at a rate of from about 10 to about 3000 sccm.

The gaseous source of oxygen may include various oxygen-containing gases including O₂, O₃, H₂O₂, and mixtures of same. Preferably, the gaseous source of oxygen will comprise a mixture of oxygen-containing gases containing at least 1 vol.% O₃, e.g., with the balance comprising O₂. The gaseous source of oxygen may also include a carrier gas such as helium, argon, or nitrogen. However, at least 10 vol.% of such a mixture must comprise an oxygen-containing gas. The gaseous source of oxygen is flowed into the vacuum deposition chamber at a rate within a range of from about 500 to about 10,000 sccm.

As previously discussed, the source of silicon consists of tetraethylorthosilicate to assure formation of an essentially void-free layer of BPSG. The tetraethylorthosilicate is usually mixed with an inert carrier gas such as argon or helium, or an oxygen-containing carrier gas. The ratio of tetraethylorthosilicate and carrier gas should be from about 0.1 vol.% to about 20 vol.% tetraethylorthosilicate. The flow rate of the tetraethylorthosilicate/carrier gas mixture into the deposition chamber is within a range of from about 100 to about 10,000 sccm.

The ratio of TEOS to O₃ may range from about 1:100 to about 2:1, but will typically be about 1:2.

The optimal total flow of the gaseous reactants into the deposition chamber to obtain the highest deposition rate will vary somewhat with the design and geometry of the particular vacuum apparatus utilized for the deposition process. If the flow rate is too high, the deposition rate will be lowered because the residence time of the gas in the chamber is too short for reaction; while use of a low flow rate results in reaction and deposition of the doped glass elsewhere in the vacuum chamber than on the silicon wafer on which the integrated circuit structures have been formed. Usually, the total flow of gases into the vacuum deposition chamber will range from about 650 sccm to about 20,000 sccm.

For example, a flow rate of about 1000 sccm TEOS-containing gas, about 2000 sccm of the O₃-containing gas, and about 50 sccm each of the gaseous sources of boron and phosphorus dopants has been found to provide a deposition rate of at least about 0,15 nm (1500 Angstroms) minute using a deposition chamber in a 5000 Series vacuum apparatus available from Applied Materials, Inc.

In accordance with the invention, the deposition time will, therefore, be controlled to permit deposition of from about 80% to about 95% of the total desired thickness of the BPSG layer in this first step of CVD deposition with the remaining 5% to 20% of the thickness formed in a second deposition step as will now be described.

This second deposition step is carried out under conditions identical to the first deposition step with regard to temperature, pressure, gaseous components, and flow rates except that during the deposition, a plasma is ignited between the susceptor on which the wafer rests and the faceplate or "showerhead" through which the gases flow into the chamber. The power level of the plasma during the plasma-assisted CVD deposition may range from about 25 to about 500 watts, preferably, from about 50 to about 200 watts.

This second deposition step results in the formation of a non-porous and non-hygroscopic BPSG cap layer over the CVD-formed BPSG layer which cap is resistant to leaching out of the boron dopant in the glass during a subsequent wet etching step to remove impurities such as other metals from the surface of the BPSG layer prior to heating of the newly formed BPSG layer to planarize the structure.

To further illustrate the practice of the invention, a silicon wafer, having a raised pattern of polysilicon previously formed thereon, was placed in a vacuum deposition chamber of an Applied Mater-ials 5000 Series vacuum apparatus under a vacuum of about 65 × 10³ Pa (500 Torr) and heated to a temperature of about 390°C. A mixture of gases was flowed over the wafer consisting of about 1000 sccm of TEOS (4 mole percent TEOS/ balance helium), about 2000 sccm of O₃ (8 wt.% O₃/92 wt.% O₂), and about 20 sccm each of triethylphosphine and trimethylborate (both dopant sources used without carrier gas) for about 2 minutes to deposit a boron phosphosilicate glass layer of about 0.8 nm in thickness on the patterned silicon wafer.

A plasma was then ignited in the chamber to a power level of 100 watts and the process was carried out for an additional 20 seconds to form a 0.1 nm plasma-assisted CVD boron phosphosilicate glass cap layer over the CVD-formed BPSG layer.

The wafer was then removed from the vacuum chamber and wet cleaned by dipping in a H₂SO₄:H₂O₂:H₂O solution for 10 minutes to remove impurities from the newly formed BPSG surface. The wafer was then heated to 850°C for 30 minutes to allow the composite BPSG layer to flow to planarize the wafer. The wafer surface was visually inspected for cracking of the BPSG layer, indicative of stress cracking. No such cracking was observed.

The wafer was then sectioned and examined under a 2000x microscope for the presence of voids in the BPSG layer in the filled in regions between the polysilicon lines. No visible signs of voids were found. The examination further showed that the glass had flowed satisfactorily, indicating that no boron had leached out of the glass.

The surface of the cap layer was examined for the presence of water by Fourier Transform Infrared Spectroscopy (FTIR Spectroscopy). No evidence of water pickup was found. The coated wafer was then exposed to ambient conditions for several days after which the surface was again examined by FTIR Spectroscopy. No water pickup was observed, indicative of the low hygroscopicity of the cap layer.

Thus, the invention provides an improved process for forming a planarizing BPSG layer on a semiconductor wafer wherein a BPSG layer essentially free of voids is formed in a first CVD step using a gaseous mixture of O₃, TEOS, and phosphorus and boron dopants; and then depositing a cap layer of BPSG which is non-hygroscopic and resistant to leaching out of the boron dopant in a second deposition step comprising a plasma-assisted CVD process.

## Claims

1. A method for forming a composite layer of boron phosphorus silicate glass (BPSG) over stepped surfaces (20,24) of a semiconductor wafer (10)
characterized by the steps:
(a) depositing a first CVD base layer (40) of BPSG on said wafer (10), in a vacuum chamber, by flowing into said vacuum chamber a mixture of gases comprising one or more gaseous sources of boron, one or more gaseous sources of phosphorus, a gaseous source of oxygen, and tetraethylorthosilicate as the gaseous source of silicon; and
(b) depositing a plasma assisted CVD capping layer (50) of BPSG over said CVD layer (40) in a vacuum chamber, by using a mixture of gases comprising one or more gaseous sources of boron, one or more gaseous sources of phosphorus, a gaseous source of oxygen, and tetraethylorthosilicate as the gaseous source of silicon while maintaining a plasma in said chamber.

2. The method of claim 1 which further comprises depositing from about 80% to about 95% of the desired thickness of said composite BPSG layer in said first step of CVD deposition and from about 5% to about 20% of the desired thickness of said composite BPSG layer during said second step of plasma-assisted CVD deposition.

3. The method of claim 1 or 2 which further comprises maintaining a pressure in said vacuum chamber within a range of from 5.2 × 10³ Pa to 0.99 × 10⁵ Pa, and a wafer temperature within a range of from about 390°C to about 600°C during said deposition steps.

4. The method of claim 1, 2 or 3 which further comprises maintaining flow rates into said vacuum chamber, during said deposition steps, of:
(a) said gaseous source of boron within a range of from about 10 sccm to about 3000 sccm;
(b) said gaseous source of phosphorus within a range of from about 10 sccm to about 3000 sccm;
c) said gaseous source of oxygen within a range of from about 500 sccm to about 10,000 sccm,; and
d) said gaseous TEOS within a range of from about 100 sccm to about 10,000 sccm;
while maintaining a total flow rate into said vacuum chamber of said gaseous sources of boron, phosphorus, oxygen and TEOS within a range of from about 650 sccm to about 20,000 sccm.

5. The method of any of claims 1 to 4 which further comprises providing at least 1 vol.% O₃ in said gaseous source of oxygen with the balance comprising one or more gases selected from the class consisting of O₂, H₂O₂, helium, argon, and nitrogen; and maintaining a ratio of TEOS to O₃ within a range of from about 1:100 to about 2:1 during said deposition steps.

6. The method of any of claims 1 to 5 wherein said gaseous source of boron is selected from the class consisting of trimethylborate, (trimethylsilyl)borate, and mixures of the same.

7. The method of any of claim 1 to 6 wherein said gaseous source of phosphorus is selected from the class consisting of triethylphosphine, trimethylphosphate, (trimethylsilyl)phosphate, and mixtures of same.

8. The method of any of claims 1 to 7, wherein said plasma in said vacuum chamber has a power level within a range of from about 25 watts to about 500 watts while continuing to flow said mixture of said one or more gaseous sources of boron, said one or more gaseous sources of phosphorus, said one or more gaseous sources of oxygen, and said tetraethylorthosilicate into said vacuum chamber.

9. An integrated circuit structure comprising a composite layer of boron phosphorus silicate glass (BPSG) deposited over a stepped surface (20, 24) of a semiconductor wafer (10), of
(a) a first essentially void-free BPSG layer (40) on said stepped surface (20, 24) of said semiconductor wafer (10) and
(b) a capping layer (50) of BPSG which is non-hygroscopic and resistant to subsequent borron loss, deposited over said first layer (40)
which composite BPSG layer is obtainable by a process according to any of Claims 1 to 8.

10. The integrated circuit structure of Claim 9, wherein said first layer (40) comprises from about 80 % to 95 % of the thickness of said composite BPSG layer, and said capping layer (50) comprises from about 5 % to about 20 % of the thickness of said composite BPSG layer.

## Patentansprüche

1. Ein Verfahren zum Ausbilden einer zusammengesetzten Schicht aus Borphosphorsilikatglas (BPSG) über abgestuften Oberflächen (20, 24) einer Halbleiterscheibe (10),
gekennzeichnet durch die Schritte:
(a) Ablagern einer ersten CVD-Grundschicht (40) aus BPSG auf der Halbleiterscheibe (10) in einer Vakuumkammer durch das Einlassen einer Mischung von Gasen, die eine oder mehrere Borgasquellen, eine oder mehrere Phosphorgasquellen, eine Sauerstoffgasquelle und Tetraethylorthosilikat als die Silziumgasquelle aufweisen, in die Vakuumkammer; und
(b) Ablagern einer plasmaunterstützten CVD-Deckschicht (50) aus BPSG über der CVD-Schicht (40) in einer Vakuumkammer durch Verwendung einer Mischung von Gasen, die eine oder mehrere Borgasquellen, eine oder mehrere Phosphorgasquellen, eine Sauerstoffgasquelle und Tetraethylorthosilikat als die Siliziumgasquelle aufweisen, während ein Plasma in der Kammer aufrechterhalten wird.

2. Das Verfahren gemäß Anspruch 1, das ferner das Ablagern von etwa 80% bis etwa 95% der gewünschten Dicke der zusammengesetzten BPSG-Schicht beim ersten Schritt der CVD-Ablagerung und von etwa 5% bis etwa 20% der gewünschten Dicke der zusammengesetzten BPSG-Schicht während des zweiten Schrittes der plasmaunterstützten CVD-Ablagerung umfaßt.

3. Das Verfahren gemäß Anspruch 1 oder 2, das ferner das Aufrechterhalten eines Druckes in der Vakuumkammer innerhalb eines Bereichs von 5,2 × 10³ Pa bis 0,99 × 10⁵ Pa und einer Halbleiterscheibentemperatur innerhalb eines Bereichs von etwa 390°C bis etwa 600°C während der Ablagerungsschritte umfaßt.

4. Das Verfahren gemäß Anspruch 1, 2 oder 3, das ferner, während der Ablagerungsschritte, das Aufrechterhalten von folgenden Strömungsgeschwindigkeiten in die Vakuumkammer umfaßt:
(a) der Borgasquelle innerhalb eines Bereichs von etwa 10 sccm bis etwa 3000 sccm;
(b) der Phosphorgasquelle innerhalb eines Bereichs von etwa 10 sccm bis etwa 3000 sccm;
(c) der Sauerstoffgasquelle innerhalb eines Bereichs von etwa 500 sccm bis etwa 10000 sccm; und
(d) des gasförmigen TEOS' innerhalb eines Bereichs von etwa 100 sccm bis etwa 10000 sccm;
während eine Gesamtströmungsgeschwindigkeit der Gasquellen von Bor, Phosphor, Sauerstoff und TEOS in die Vakuumkammer aufrechterhalten wird, die innerhalb eines Bereichs von 650 sccm bis etwa 20000 sccm liegt.

5. Das Verfahren gemäß irgendeinem der Ansprüche 1 bis 4, das ferner das Bereitstellen von mindestens 1 Vol.-% O₃ in der Sauerstoffgasquelle, wobei der Rest ein oder mehrere Gase umfaßt, die aus der aus O₂, H₂O₂, Helium, Argon und Stickstoff bestehenden Klasse ausgewählt werden; und das Aufrechterhalten eines Verhältnisses von TEOS zu O₃ innerhalb eines Bereichs von etwa 1:100 bis etwa 2:1 während der Ablagerungsschritte umfaßt.

6. Das Verfahren gemäß irgendeinem der Ansprüche 1 bis 5, bei dem die Borgasquelle aus der aus Trimethylborat, (Trimethylsilyl)Borat und Mischungen derselben bestehenden Klasse ausgewählt wird.

7. Das Verfahren gemäß irgendeinem der Ansprüche 1 bis 6, bei dem die Phosphorgasquelle aus der aus Trietylphosphin, Trimethylphosphat, (Trimethylsilyl)Phosphat und Mischungen derselben bestehenden Klasse ausgewählt wird.

8. Das Verfahren gemäß irgendeinem der Ansprüche 1 bis 7, bei dem das Plasma in der Vakuumkammer einen Leistungspegel innerhalb eines Bereichs von etwa 25 Watt bis etwa 500 Watt aufweist, während das Fließen der Mischung aus einer oder mehrerer Borgasquellen, einer oder mehrerer Phosphorgasquellen, einer oder mehrerer Sauerstoffgasquellen und von Tetraethylorthosilikat in die Vakuumkammer aufrechterhalten wird.

9. Eine integrierte Schaltungsstruktur, die eine zusammengesetzte Schicht aus Borphosphorsilikatglas (BPSG) aufweist, die über einer abgestuften Oberfläche (20, 24) einer Halbleiterscheibe (10) abgelagert wird, bestehend aus
(a) einer ersten im wesentlichen hohlraumfreien BPSG-Schicht (40) auf der abgestuften Oberfläche (20, 24) der Halbleiterscheibe (10) und
(b) einer BPSG-Deckschicht (50), die nicht hygroskopisch und beständig gegen nachfolgenden Borverlust ist, und die über der ersten Schicht (40) abgelagert ist,
wobei die zusammengesetzte BPSG-Schicht durch ein Verfahren gemäß irgendeinem der Ansprüche 1 bis 8 erhaltbar ist.

10. Die integrierte Schaltungsstruktur gemäß Anspruch 9, bei der die erste Schicht (40) etwa 80% bis 95% der Dicke der zusammengesetzten BPSG-Schicht aufweist, und die Deckschicht (50) etwa 5% bis etwa 20% der Dicke der zusammengesetzten BPSG-Schicht aufweist.

## Revendications

1. Procédé de formation d'une couche composite de verre boro-phospho silicaté (BPSG) sur des surfaces en échelons (20, 24) d'une tranche de semi-conducteur (10) caractérisé par les étapes consistant à :
(a) déposer une première couche de base par dépôt chimique en phase vapeur (40) de verre boro-phospho silicaté sur ladite tranche (10) dans une enceinte sous vide, en faisant circuler dans ladite enceinte sous vide un mélange de gaz comprenant une ou plusieurs sources gazeuses de bore, une ou plusieurs sources gazeuses de phosphore, une source gazeuse d'oxygène et du tétraéthylorthosilicate en tant que source gazeuse de silicium, et
(b) déposer une couche de coiffe par dépôt chimique en phase vapeur activé par plasma (50) de verre boro-phospho silicaté sur ladite couche de dépôt chimique en phase vapeur (40) dans une enceinte sous vide, en utilisant un mélange de gaz comprenant une ou plusieurs sources gazeuses de bore, une ou plusieurs sources gazeuses de phosphore, une source gazeuse d'oxygène et du tétraéthylorthosilicate comme source gazeuse de silicium tout en maintenant un plasma dans ladite enceinte.

2. Procédé selon la revendication 1 comprenant en outre le dépôt d'environ 80 % à environ 95 % de l'épaisseur désirée de ladite couche de verre boro-phospho silicaté composite lors de ladite première étape de dépôt chimique en phase vapeur et d'environ 5 % à environ 20 % de l'épaisseur désirée de ladite couche de verre boro-phospho silicaté composite pendant ladite seconde étape de dépôt chimique en phase vapeur activé par plasma.

3. Procédé selon la revendication 1 ou la revendication 2 consistant en outre à conserver une pression dans ladite enceinte sous vide à l'intérieur d'une plage de 5,2 x 10³ Pa à 0,99 x 10⁵ Pa et une température de tranche à l'intérieur d'une plage allant d'environ 390°C à environ 600°C pendant lesdites étapes de dépôt.

4. Procédé selon la revendication 1, la revendication 2 ou la revendication 3, lequel comprend en outre le maintien des débits dans ladite enceinte sous vide pendant lesdites étapes de dépôt, constitués de :
(a) ladite source gazeuse de bore à l'intérieur d'une plage allant d'environ 10 centimètres cubes standards par minute à environ 3 000 centimètres cubes standards par minute,
(b) ladite source gazeuse de phosphore à l'intérieur d'une plage allant d'environ 10 centimètres cubes standards par minute à environ 3 000 centimètres cubes standards par minute,
(c) ladite source gazeuse d'oxygène à l'intérieur d'une plage allant d'environ 500 centimètres cubes standards par minute à environ 10 000 centimètres cubes standards par minute, et
(d) ledit tétraéthylorthosilicate gazeux à l'intérieur d'une plage allant d'environ 100 centimètres cubes standards par minute à environ 10 000 centimètres cubes standards par minute,
tout en conservant un débit total dans ladite enceinte sous vide desdites sources gazeuses de bore, de phosphore, d'oxygène et de tétraéthylorthosilicate à l'intérieur d'une plage allant d'environ 650 centimètres cubes standards par minute à environ 20 000 centimètres cubes standards par minute.

5. Procédé selon l'une quelconque des revendications 1 à 4, lequel consiste en outre à procurer au moins 1 % en volume d'O₃, dans ladite source gazeuse d'oxygène, le complément étant constitué d'un ou plusieurs gaz choisis à partir de la classe constituée de O₂, H₂O₂, hélium, argon et azote et à maintenir un rapport de tétraéthylorthosilicate sur O₃ à l'intérieur d'une plage allant d'environ 1:100 à environ 2:1 pendant lesdites étapes de dépôt.

6. Procédé selon l'une quelconque des revendications 1 à 5, dans lequel ladite source gazeuse de bore est sélectionnée à partir de la classe constituée du triméthylborate, du (triméthylsilyl) borate et des mélanges de ceux-ci.

7. Procédé selon l'une quelconque des revendications 1 à 6, dans lequel ladite source gazeuse de phosphore est sélectionnée à partir de la classe constituée de la triéthylphosphine, du triméthylphosphate, du (triméthylsilyl)phosphate et des mélanges de ceux-ci.

8. Procédé selon l'une quelconque des revendications 1 à 7, dans lequel ledit plasma dans ladite enceinte sous vide présente un niveau de puissance situé à l'intérieur d'une plage allant d'environ 25 watts à environ 500 watts tout en continuant à faire circuler ledit mélange desdites une ou plusieurs sources gazeuses de bore, desdites une ou plusieurs sources gazeuses de phosphore, desdites une ou plusieurs sources gazeuses d'oxygène et dudit tétraéthylorthosilicate dans ladite enceinte sous vide.

9. Structure de circuit intégré comportant une couche composite de verre boro-phospho silicaté (BPSG) déposée sur une surface en échelons (20, 24) d'une tranche de semi-conducteur (10), constituée de
(a) une première couche de verre boro-phospho silicaté pratiquement dépourvu de vides sur ladite surface en échelons (20, 24) de ladite tranche de semi-conducteur (10) et,
(b) une couche de coiffe (50) de verre boro-phospho silicaté qui est non hygroscopique et résistante à une perte de bore ultérieure, déposée sur ladite première couche (40),
laquelle couche de verre boro-phospho silicaté composite peut être obtenue par un processus conforme à l'une quelconque des revendications 1 à 8.

10. Structure de circuit intégré selon la revendication 9, dans laquelle ladite première couche (40) constitue environ 80 % à environ 95 % de l'épaisseur de ladite couche de verre boro-phospho silicaté composite et ladite couche de coiffe (50) constitue environ 5 % à environ 20 % de l'épaisseur de ladite couche de verre boro-phospho silicaté composite.
